# EUROPÄISCHE PATENTSCHRIFT

(11) **EP 2 002 544 B1**
(45) Veröffentlichungstag und Bekanntmachung des Hinweises auf die Patenterteilung: **04.05.2011**
(21) Anmeldenummer: 07711866.9
(22) Anmeldetag: 09.03.2007
(51) Int. Cl.: H03K 17/97

(54) **SCHALTER, INSBESONDERE FAHRZEUGSCHALTER, AUSWERTEEINHEIT HIERFÜR UND ZUGEHÖRIGE SCHALTEREINHEIT**
SWITCH, IN PARTICULAR A VEHICLE SWITCH, EVALUATION DEVICE THEREFOR AND ASSOCIATED SWITCH UNIT
COMMUTATEUR, EN PARTICULIER COMMUTATEUR POUR VÉHICULE, UNITÉ D'ÉVALUATION POUR CE COMMUTATEUR ET UNITÉ À COMMUTATEUR CORRESPONDANTE

(30) Priorität: 13.03.2006 DE 102006012891
(43) Veröffentlichungstag der Anmeldung: 17.12.2008
(73) Patentinhaber: Valeo Schalter und Sensoren GmbH, 74321 Bietigheim-Bissingen (DE)
(72) Erfinder: MOZER, Reiner, 71665 Vaihingen/Enz (DE); HORST, Daniel, 74321 Bietigheim-Bissingen (DE); KARGER, Margit, 74385 Pleidelsheim (DE)
(74) Vertreter: Pothmann, Karsten
(86) Internationale Anmeldenummer: PCT/EP2007/002044
(87) Internationale Veröffentlichungsnummer: WO 2007/104478

(56) Entgegenhaltungen:
- DE-A1- 4 006 596
- DE-C1- 19 603 197
- FR-A1- 2 644 622
- US-A- 2 632 058

## Beschreibung

Die Erfindung betrifft einen Schalter, insbesondere Fahrzeugschalter, mit einem mit einem Betätigungselement koppelbaren, entlang einer Verschieberichtung verschieblich gelagerten und in definierte, insbesondere einrastende Schaltstellungen bringbaren Schaltstück. Die Erfindung betrifft außerdem eine zugehörige Auswerteeinheit und eine Schaltereinheit, umfassend einen derartigen Schalter samt Auswerteeinheit.

Schalter, insbesondere Fahrzeugschalter, sind in vielfältiger Art und Weise aus dem Stand der Technik vorbekannt. Dabei werden die vom Schalter erzeugten Schaltsignale in der Regel parallel übertragen und verarbeitet, wobei für jede Schaltstellung eine eigene Signalleitung erforderlich ist. Werden in den jeweiligen Schaltstellungen elektrische Kontakte geschlossen oder unterbrochen, so tritt hierbei Verschleiß auf. Zudem sind entsprechende Betätigungskräfte erforderlich, die einen entsprechenden Kontakt öffnen beziehungsweise schließen.

Aus der DE 196 03 197 C1, der DE 40 06 596 A1 und der FR-A1 2 644 622 sind verschiedene Schalter vorbekannt.

Bei bekannten Schaltern hat sich zudem als problematisch herausgestellt, dass die erzeugten Schaltsignale zur Übertragung an eine Auswerteeinheit, beziehungsweise in einer Auswerteeinheit widerstands- oder spannungscodiert werden, um sie dort digital verarbeiten zu können.

Der vorliegenden Erfindung liegt die Aufgabe zugrunde, einen eingangs genannten Schalter, insbesondere einen Fahrzeugschalter, derart weiterzubilden, dass zum einen ein dauerhaftes funktionssicheres Erkennen der einzelnen Schaltstellungen ermöglicht wird und zum anderen eine einfache Signalübertragung an eine Auswerteeinheit erreicht wird.

Diese Aufgabe wird durch einen Schalter mit den Merkmalen des Anspruchs 1 gelöst. Ein derartiger Schalter weist einen mit einem Betätigungselement koppelbaren, entlang einer Verschieberichtung verschieblich gelagerten und in insbesondere einrastbare Schaltstellungen bringbaren Schieber auf. Der Schieber ist dabei wenigstens bedingt mit wenigstens zwei je wenigstens einen Süd- und/oder Nordpolabschnitt aufweisenden Dauermagneten über geeignete Schaltstücke bewegungsgekoppelt. Ferner sind wenigstens zwei gegenüber dem Schieber ortsfest angeordnete, je einem Dauermagneten zugeordnete Magnetfeldsensoren vorgesehen, deren Ausgangssignale je nach Schaltstellung des Schiebers davon abhängen, ob ein Süd- oder Nordpolabschnitt des jeweiligen Dauermagneten im Erfassungsbereich des jeweiligen Magnetfeldsensors liegt und deren Ausgangssignale in der jeweiligen Schaltstellung einen eindeutig bestimmbaren binären Schaltcode bilden. Die Schaltstücke sind dabei grundsätzlich unabhängig voneinander, aber abhängig von der Schaltstellung des Schiebers, angeordnet. Zur Bewegungskopplung mit dem Schieber weisen die Schaltstücke Führungszapfen auf, wobei der Schieber dann für jeden Führungszapfen eine geeignete Kulissenführung aufweist.

Ein derartiger Schalter hat den Vorteil, dass aufgrund des berührungslosen Erkennens der jeweiligen Schaltstellung durch die Magnetfeldsensoren kein Verschleiß auftritt. Ferner wird aufgrund der Ausgangssignale der Magnetfeldsensoren, die den binären Schaltcode bilden, erreicht, dass der Schaltcode unmittelbar einer entsprechenden Auswerteeinheit zur Verfügung gestellt werden kann. Aufgrund des eindeutig bestimmbaren Schaltcodes kann auf die jeweilige Schaltstellung des Schaltstücks eindeutig rückgeschlossen werden. Durch Vorsehen der Kulissenführung kann beim Verschieben des Schiebers in Verschieberichtung eine entsprechende Auslenkung des Schaltstücks erreicht werden. Gemäß einer vorteilhaften Ausgestaltung der Erfindung ist in jeder Schaltstellung des Schiebers in den Erfassungsbereichen der Magnetfeldsensoren entweder ein Nord- oder Südpolabschnitt des dem jeweiligen Magnetfeldsensor zugehörigen Dauermagneten vorhanden. Dadurch ergibt sich eine eindeutige Polerkennung durch den jeweiligen Magnetfeldsensor; entweder wird ein Nordpol oder ein Südpol erkannt. Zudem ergibt sich hierdurch ein ausreichend guter Schutz gegen äußere Störmagnetfelder, die zu einem verfälschten Schaltcode führen können.

Gemäß einer weiteren vorteilhaften Ausgestaltung der Erfindung kann vorgesehen sein, dass der Schalter einen Halter umfasst, der den Schieber entlang einer geradlinig verlaufenden Verschieberichtung verschiebbar führt und/oder an den die Schaltstücke derart beweglich angeordnet sind, dass sie ihre relative Lage bezüglich den Magnetfeldsensoren in Abhängigkeit der Schaltstellung des Schiebers ändern. Ein derartiger Halter kann folglich eine Doppelfunktion erfüllen; zum einen bildet er die Führung für den Schieber und zum anderen dient er zur beweglichen Anordnung der Schaltstücke.

Die Schaltstücke können dabei wenigstens weitgehend senkrecht zur Verschieberichtung des Schiebers zwischen zwei Schiebeendladen beweglich angeordnet sein. Beim Bewegen des Schiebers von einer Schaltstellung in eine benachbarte Schaltstellung kann das jeweilige Schaltstück quer zur Verschieberichtung bewegt werden. Dabei kann in der einen Schiebeendlage der eine Polabschnitt und/oder in der anderen Schiebeendlage der jeweils andere Polabschnitt des zugehörigen Dauermagneten in den Erfassungsbereich des dem Dauermagneten zugehörigen.Magnetfeldsensors eingreifen.

Gemäß der Erfindung ist ebenfalls denkbar, dass die Schaltstücke zwischen zwei Schwenkendlagen schwenkbar angeordnet sind. Beim Bewegen des Schaltstücks von einer Schaltstellung in eine andere Schaltstellung kann dann das Schaltstück um eine Schwenkachse derart verschwenkt, dass in der einen Schwenkendlage vorteilhafterweise der eine Polabschnitt und in einer anderen Schwenkendlage der jeweils andere Polabschnitt des Dauermagneten in den Erfassungsbereich des zugehörigen Magnetfeldsensors eingreift.

Die einzelnen Kulissenführungen weisen dabei vorteilhafterweise parallel zueinander und parallel zur Verschieberichtung verlaufende Teilabschnitte auf. Befindet sich der Führungszapfen in einem Teilabschnitt, so kann vorteilhafterweise der eine Polabschnitt im Erfassungsbereich des Magnetfeldsensors sein. Befindet sich der Führungszapfen in einem parallel dazu verlaufenden, anderen Teilabschnitt, so kann der andere Polabschnitt im Erfassungsbereich des zugehörigen Magnetfeldsensors vorhanden sein. Zwischen den parallel zueinander verlaufenden Teilabschnitten können schräg zur Verschieberichtung verlaufende, die jeweiligen parallel verlaufenden Teilabschnitte verbindende Verbindungsabschnitte vorgesehen sein.

Die Führungszapfen sind dabei vorteilhafterweise wenigstens weitgehend entlang einer quer zur Verschieberichtung des Schiebers verlaufenden Linie angeordnet. Insbesondere verlaufen die Führungszapfen senkrecht zur Verschiebeebene des Schiebers.

Zum erleichterten Einführen der Führungszapfen in die entsprechenden Kulissenführungen kann vorgesehen sein, dass die Kulissenführungen im Bereich wenigstens eines offenen Endes sich in quer zur Verschieberichtung erstreckende, insbesondere innerhalb der Verschiebeebene liegende Öffnungsaufweitungen aufweisen. Die Öffnungsaufweitungen weisen dabei vorzugsweise ein maximales Öffnungsmaß auf, das gleich oder geringfügig größer des maximalen Bewegungsspielraums der Führungszapfen quer zur Verschieberichtung ist.

Die Süd- und Nordpolabschnitte des Dauermagneten und/oder die Kulissenführungen können dabei derart angeordnet sein, dass beim Verschieben des Schiebers von einer Schaltstellung in eine benachbarte Schaltstellung sich der Schaltcode um lediglich ein Ausgangssignal eines Magnetfeldsensors ändert. Die Anzahl der Magnetfeldsensoren entspricht dabei grundsätzlich der Anzahl der Bits des Schaltcodes. Beim Schalten des Schaltstücks in eine benachbarte Schaltstellung ändert sich dann lediglich ein Bit des Schaltcodes.

Ferner ist denkbar, dass Rastmittel vorgesehen sind, die den Schieber in der jeweiligen Schaltstellung lösbar rastend halten. Der Schieber kann aufgrund der Rastmittel definierte Schaltstellungen einnehmen. Die Rastmittel sind dabei vorzugsweise einerseits am Halter angeordnet und wirken andererseits gegen den Schieber.

Gemäß einer weiteren vorteilhaften Ausgestaltung der Erfindung sieht der Schalter zwei Magnetfeldsensoren und maximal vier Schaltstellungen oder drei Magnetfeldsensoren und maximal acht Schaltstellungen vor. Bei Vorsehen von zwei Magnetfeldsensoren finden insbesondere zwei Schaltstücke mit jeweils einem Dauermagnet Verwendung; bei Vorsehen von drei Magnetfeldsensoren finden drei Schaltstücke mit jeweils vorzugsweise einem Dauermagnet Verwendung. Die zur Verwendung kommenden Dauermagneten sehen dabei insbesondere jeweils lediglich einen Nordpolabschnitt und einen Südpolabschnitt vor.

Gemäß einer Weiterbildung der Erfindung ist denkbar, dass in einer Neutralstellung des Schiebers beziehungsweise der Schaltstücke kein Süd- oder Nordpolabschnitt der Dauermagneten in den Erfassungsbereichen der Magnetfeldsensoren vorhanden ist. Eine derartige Neutralstellung kann beispielsweise als Referenzpunkt vorgesehen sein, in dem die Magnetfeldsensoren eine Detektionslücke erkennen.

Gemäß einer Weiterbildung der Erfindung können die Schaltstücke aus Kunststoff ausgebildet sein, wobei dann die Dauermagnete in die Schaltstücke eingeformt oder an diesem befestigt sein können. Das Einformen der Dauermagneten in die Schaltstücke hat den Vorteil, dass der Dauermagnet dauerhaft sicher geschützt ist.

Als Magnetfeldsensoren können beispielsweise auf einer Leiterplatte angeordnete Hall-Ics Verwendung finden. Bei Eintreten eines Nordpolabschnitts in den Erfassungsbereich eines Hall-Ics wird dieser beispielsweise eingeschaltet; bei Eintreten eines Nordpols in den Erfassungsbereich des Hall-Ics wird dieser beispielsweise wieder sicher ausgeschaltet.

Die eingangs genannte Aufgabe wird auch durch eine Auswerteeinheit für einen erfindungsgemäßen Schalter gelöst, wobei eine derartige Auswerteeinheit aus dem jeweiligen Schaltcode des Schalters eine zugehörige Schaltstellung bestimmt und einen entsprechenden Schaltvorgang einleitet. Die Auswerteeinheit kann dabei unmittelbar am Schalter angeordnet oder fern vom Schalter vorgesehen sein.

Vorteilhaft ist, wenn die Auswerteeinheit die Abfolge der Schaltcodes auf Plausibilität und/oder Redundanz überprüft. Dabei kann die Abfolge der Schaltcodes in der Auswerteeinheit hinterlegt sein, wobei dann beim tatsächlichen Schaltvorgang verglichen wird, ob die tatsächliche Abfolge der Schaltcodes mit der hinterlegten Abfolge der Schaltcodes übereinstimmt. Ferner kann überprüft werden, in welche Richtung der Schieber bewegt wird.

Die Auswerteeinheit kann gemäß der Erfindung den unmittelbar von den Magnetfeldsensoren erzeugten Schaltcode auswerten. Dies hat den Vorteil, dass keine Zwischencodierung und/oder keine Zwischenwandlung der Signale zu erfolgen hat. Allerdings ist von der Erfindung auch umfasst, dass der von den Magnetfeldsensoren erzeugte Schaltcode vor einer Auswertung durch die Auswerteeinheit in ein digitales Signal umgewandelt wird. Hierzu kann beispielsweise in A/D-Wandler und/oder eine entsprechende Widerstands- oder Spannungscodierung Verwendung finden.

Die eingangs genannte Aufgabe wird zudem gelöst durch eine Schaltereinheit, die einen erfindungsgemäßen Schalter sowie eine erfindungsgemäße Auswerteeinheit umfasst.

Weitere Einzelheiten und vorteilhafte Ausgestaltungen der Erfindung sind der nachfolgenden Beschreibung zu entnehmen, anhand derer das in den Figuren dargestellte Ausführungsbeispiel der Erfindung näher beschrieben und erläutert ist.

Es zeigen:
- Figur 1: einen erfindungsgemäßen Schalter ohne Schieber;
- Figur 2: den Schalter gemäß Figur 1 mit Schieber;
- Figur 3: den Schieber gemäß Figur 2 samt Schaltstücken und Magnetfeldsensoren ohne Halter;
- Figur 4: die Unteransicht des Schalters gemäß Figur 2;
- Figur 5: eine Tabelle mit den binären Schaltcodes der Schaltstücke in verschiedenen Schaltstellungen; und
- Figur 6: eine schematische Darstellung einer erfindungsgemäßen Schaltereinheit mit Schalter und Auswerteeinheit.

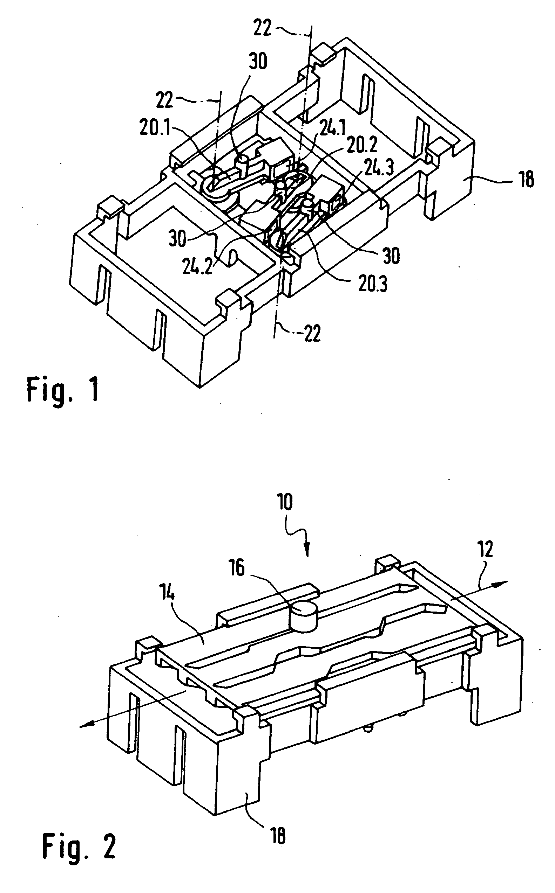

Der in den Figuren 1 bis 4 dargestellte Schalter 10 umfasst ein mit einem in den Figuren nicht dargestellten Betätigungselement koppelbaren, entlang einer Verschieberichtung 12 verschieblich gelagerten Schieber 14. Der Schieber 14 ist dabei in definierte Schaltstellungen ST bringbar. Zur lösbaren, rastbaren Halterung des Schiebers 14 in den Schaltstellungen sind in den Figuren nicht dargestellte Rastmittel vorhanden. Zur Kopplung des Schiebers 14 mit einem in den Figuren nicht dargestellten Betätigungselement weist der Schieber einen in der Figur 2 deutlich zu erkennenden Kopplungszapfen 16 auf.

Der Schieber 14 ist dabei in einem Halter 18 verschieblich gelagert angeordnet.

Wie aus Figur 1 deutlich wird, sind am Halter drei Schaltstücke 20.1, 20.2 und 20.3 um jeweils eine Schwenkachse 22 wenigstens bedingt schwenkbar angeordnet. Die Schaltstücke 20 verlaufen dabei in einer neutralen Mittellage in Verschieberichtung 12 des Schiebers 14.

Die Schaltstücke 20 weisen auf ihrer jeweils der zugehörigen Schwenkachse 22 abgewandten Seite einen Dauermagneten 24 auf, der jeweils einen Nordpolabschnitt und einen Südpolabschnitt vorsieht. Die Nord- und Südpolabschnitte sind dabei jeweils quer zur Verschieberichtung 12 nebeneinander liegend angeordnet. Die Dauermagneten 24 sind vorteilhafterweise in die aus Kunststoff ausgebildeten Schaltstücke 20 eingeformt.

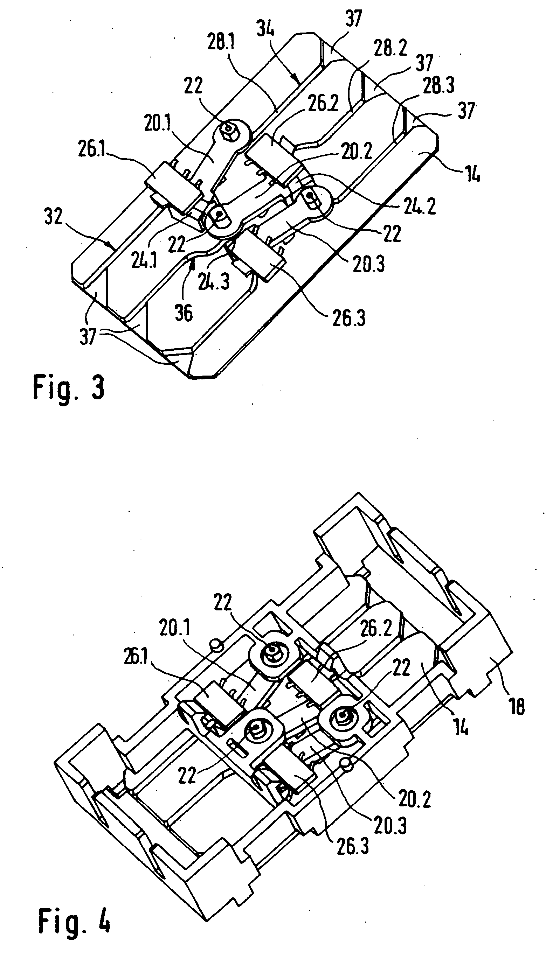

Der Schalter 10 umfasst ferner drei Magnetfeldsensoren 26.1. 26.2 und 26.3, wobei der Magnetfeldsensor 26.1 dem Dauermagnet 24.1 des Schaltstücks 20.1, der Magnetfeldsensor 26.2 dem Dauermagneten 24.2 des Schaltstücks 20.2 und der Magnetfeldsensor 26.3 dem Dauermagneten 24.3 des Schaltstücks 20.3 zugeordnet ist. Die Magnetfeldsensoren 26 sind insbesondere in den Unteransichten gemäß den Figuren 3 und 4 deutlich zu erkennen. Die drei Magnetfeldsensoren 26 können dabei auf einer in den Figuren nicht dargestellten Leiterplatte angeordnet sein, die ebenfalls am Halter 16 befestigt sein kann.

Bei Verschieben des Schiebers 14 in die jeweiligen Schaltstellungen ändern sich die Ausgangssignale der drei Magnetfeldsensoren 26.1, 26.2 und 26.3 aufgrund der sich jeweils ändernden Süd- oder Nordpolabschnitte der Dauermagneten 24.1, 24.2 und 24.3 in den Erfassungsbereichen der jeweiligen Magnetfeldsensoren 26. Die drei Ausgangssignale der Magnetfeldsensoren bilden in den einzelnen Schaltstellungen einen von einer Auswerteeinheit eindeutig bestimmbaren binären Schaltcode.

Zur Bewegungskopplung des Schiebers 14 mit den drei Schaltstücken 20 weist der Schieber 14 auf der den Schaltstücken 20 zugewandten Seite drei nutartig ausgebildete Kulissenführungen 28.1. 28.2 und 28.3 auf. Im montierten Zustand des Schalters 10 greift in jede der Kulissenführungen 28 ein am zugehörigen Schaltstück 20 vorgesehener Führungszapfen 30 ein. Beim Verschieben des Schiebers 14 in die Verschieberichtung 12 werden die Schaltstücke 20 je nach Verlauf der zugehörigen Kulissenführung 28 derart ausgelenkt, dass entweder ein Nordpolabschnitt oder ein Südpolabschnitt in den Erfassungsbereich des zugehörigen Magnetfeldsensors 26 gelangt. Dazu weisen die Kulissenführungen 28 parallel zueinander verlaufende Teilabschnitte 32, 34 auf, die parallel zur Verschieberichtung 12 verlaufend angeordnet sind. Befindet sich der jeweils zugehörige Führungszapfen 30 in dem einen Teilabschnitt 32 der Kulissenführung, so ist der eine Polabschnitt des zugehörigen Dauermagneten im Erfassungsbereich des zugehörigen Magnetfeldsensors; befindet sich der Führungszapfen 30 in dem dazu parallelen, anderen Teilabschnitt 34 der Kulissenführung 28, so befindet sich der jeweils andere Polabschnitt im Erfassungsbereich des jeweils zugehörigen Magnetfeldsensors 26. Zwischen den einzelnen Teilabschnitten 32, 34 können schräg zur Verschieberichtung verlaufende Verbindungsabschnitte 36 vorgesehen sein.

Die Polabschnitte der Dauermagneten 24 sind in Verbindung mit den Verläufen der Kulissenführungen 28 vorzugsweise derart angeordnet, dass beim Verschieben des Schiebers von einer Schaltstellung in eine benachbarte Schaltstellung sich der von den Magnetfeldsensoren 26 gebildete Schaltcode sich um lediglich ein Ausgangssignal ändert.

An den beiden freien Enden weisen die Kulissenführungen 28 sich quer zur Verschieberichtung erstreckende Öffnungsaufweitungen 37 auf. Aufgrund des Vorsehens derartiger Öffnungsaufweitungen wird beim Einschieben des Schiebers 14 in den Halter 18 gewährleistet, dass die Führungszapfen 30 zwangsweise in die Kulissenführungen 28 finden.

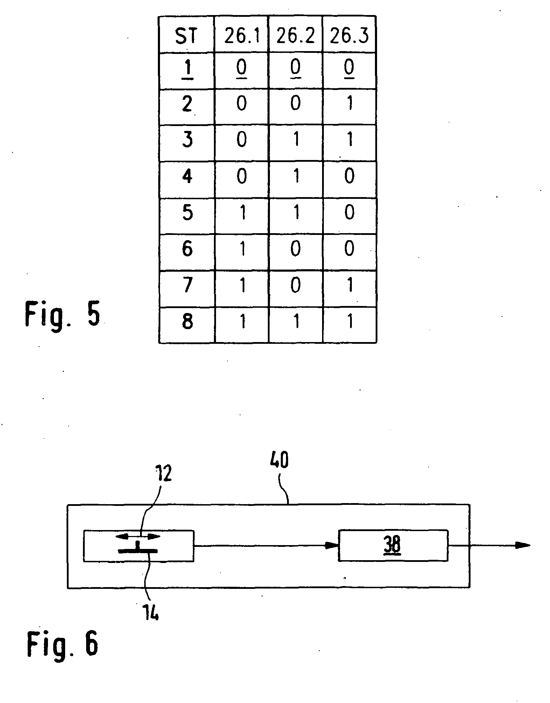

Der in den Figuren 1 bis 4 dargestellten Schalter 10 kann bei Vorsehen von drei Magnetfeldsensoren und einer entsprechend Ausbildung der Kulissenführungen 28 maximal acht Schaltstellungen ST1 bis ST8 vorsehen, wobei denkbare zugehörige Ausgangssignale der Magnetfeldsensoren 26.1, 26.2 und 26.3 in der Figur 5 tabellarisch wiedergegeben sind. Denkbar ist, dass in einer Schaltstellung ST1 in den Erfassungsbereichen der drei Magnetfeldsensoren 26.1, 26.2 und 26.3 jeweils Nordpolabschnitte der Dauermagneten 24.1, 24.2 und 24.3 vorhanden sind. Die einzelnen Ausgangssignale der Magnetfeldsensoren weisen dann den Wert 0 auf; der zugehörige binäre Schaltcode lautet folglich 000. Wird der Schieber 14 in Verschieberichtung 12 in eine zweite Schaltstellung ST2 bewegt, so kann vorgesehen sein, dass sich der binäre Schaltcode beim Magnetfeldsensor 26.3 um lediglich ein Bit ändert; in den Erfassungsbereich des Magnetfeldsensors 26.3 gelangt dann aufgrund des Verschwenkens des Schaltstücks 20.3 ein Südpolabschnitt. Insofern ergibt sich in der Schaltstellung ST2 der binäre Schaltcode 001. In einer Schaltstellung ST3 kann sich der Polabschnitt im Erfassungsbereich des Magnetfeldsensors 26.2 aufgrund einer entsprechenden. Ausbildung der Kulissenführung 28.2 ändern; der Schaltcode lautet dann: 011. Weitere denkbare Schaltcode in den weiteren Schaltstellungen ST4 bis ST 8 sind der Tabelle gemäß Figur 5 zu entnehmen. Der Tabelle gemäß Figur 5 kann zudem entnommen werden, dass sich aufgrund einer entsprechenden Ausbildung des Schalters 10 beim weiteren Verschieben des Schiebers 14 von einer Schaltstellung in eine benachbarte Schaltstellung sich der Schaltcode immer lediglich um ein Ausgangssignal eines Magnetfeldsensors 26 beziehungsweise um lediglich ein Bit ändert. Bei Vorsehen von drei Magnetfeldsensoren 26 können insgesamt maximal acht verschiedene Schaltstellungen ST1 bis ST8 eindeutig erkannt werden.

Zur Auswertung der von dem Schalter 10 erzeugten Schaltcode findet gemäß Figur 6 eine Auswerteeinheit 38 Verwendung, die aus den Schaltcoden die jeweilige Schaltstellung bestimmt und entsprechende Schaltvorgänge einleitet. Die Auswerteeinheit 38 kann dabei die Abfolge der Schaltcode auf Plausibilität überprüfen. Dazu ist vorteilhaft, wenn die Abfolge der Schaltcode in der Auswerteeinheit 38 hinterlegt ist. Gerade dann, wenn sich, wie in Figur 5 dargestellt, die Schaltcode von zwei benachbarten Schaltstellungen um lediglich ein Bit unterscheiden, kann eine entsprechende Überprüfung des Schaltvorgangs auf einfache Art und Weise erfolgen. Die von den Magnetfeldsensoren 26 erzeugten Schaltsignale können dabei direkt der Auswerteeinheit 38 zur Verfügung gestellt werden oder mittels entsprechenden Wandlern in digitale Signale umgewandelt werden. Der Schalter 10 und die entsprechende Auswerteeinheit 38 sind dabei Bestandteile einer Schaltereinheit 40. Die Auswerteeinheit 38 kann dabei beispielsweise auf der Leiterplatte, auf der die Magnetfeldsensoren angeordnet sind, oder fern von dieser angeordnet sein.

## Patentansprüche

1. Schalter (10), insbesondere Fahrzeugschalter, mit einem mit einem Betätigungselement koppelbaren, entlang einer Verschieberichtung (12) veschieblich gelagerten und in definierte Schaltstellungen (ST1 bis ST8) bringbaren Schieber (14), wobei der Schieber (14) über Schaltstücke (20) mit wenigstens zwei je wenigstens einen Süd- und/oder Nordpolabschnitt aufweisenden Dauermagneten (24) wenigstens bedingt bewegungsgekoppelt ist, und mit wenigstens zwei gegenüber dem Schieber (14) ortsfest angeordneten, je einem Dauermagneten (24) zugeordneten Magnetfeldsensoren (26), deren Ausgangssignale je nach Schaltstellung (ST1 bis ST8) des Schiebers (14) davon abhängen, ob ein Süd- oder Nordpolabschnitt des jeweiligen Dauermagneten (24) im Erfassungsbereich des jeweiligen Magnetfeldsensors (26) liegt und deren Ausgangssignale in der jeweiligen Schaltstellung (ST1 bis ST8) einen eindeutig bestimmbaren binären Schaltcode bilden, **dadurch gekennzeichnet, dass** die Schaltstücke (20) zur Bewegungskopplung mit dem Schieber (14) je einen Führungszapfen (30) aufweisen und dass der Schieber (14) für jeden Führungszapfen (30) eine Kulissenführung (28) zur Führung des jeweiligen Führungszapfens (30) aufweist.

2. Schalter (10) nach Anspruch 1, **dadurch gekennzeichnet, dass** in jeder Schaltstellung (ST1 bis ST8) des Schiebers (14) in den Erfassungsbereichen der Magnetfeldsensoren (26) entweder ein Nord- oder Südpolabschnitt des dem jeweiligen Magnetfeldsensor (26) zugehörigen Dauermagneten (24) vorhanden ist.

3. Schalter (10) nach Anspruch 1 oder 2, **dadurch gekennzeichnet, dass** der Schalter einen Halter (18) umfasst, der den Schieber (14) entlang einer geradlinig verlaufenden Verschieberichtung (12) verschiebbar führt und/oder an dem die Schaltstücke (20) derart beweglich angeordnet sind, dass sie ihre relative Lage bezüglich den Magnetfeldsensoren (26) in Abhängigkeit der Schaltstellung des Schiebers (24) ändern.

4. Schalter (10) nach Anspruch 1, 2 oder 3, **dadurch gekennzeichnet, dass** die Schaltstücke (20) wenigstens weitgehend senkrecht zur Verschieberichtung (12) des Schiebers (14) zwischen zwei Schiebeendlagen beweglich angeordnet sind.

5. Schalter (10) nach Anspruch 1, 2 oder 3, **dadurch gekennzeichnet, dass** die Schaltstücke (20) zwischen zwei Schwenkendlagen schwenkbar angeordnet sind.

6. Schalter (10) nach einem der vorhergehenden Ansprüche, **dadurch gekennzeichnet, dass** die Kulissenführungen (28) parallel zueinander und parallel zur Verschieberichtung verlaufende Teilabschnitte (32, 34) aufweisen.

7. Schalter (10) nach einem der vorhergehenden Ansprüche, **dadurch gekennzeichnet, dass** die Kulissenführungen (28) im Bereich wenigstens eines offenen Endes sich in quer zur Verschieberichtung erstreckende Öffnungsaufweitungen (37) zur erleichterten Einführung der Führungszapfen (30) aufweisen.

8. Schalter (10) nach einem der vorhergehenden Ansprüche, **dadurch gekennzeichnet, dass** die Süd- und Nordpolabschnitte der Dauermagnete (24) und/oder, wenn auf Anspruch 8 rückbezogen, die Kulissenführungen (28) derart angeordnet sind, dass beim Verschieben des Schiebers (14) von einer Schaltstellung in eine benachbarte Schaltstellung sich der Schaltcode um lediglich ein Ausgangssignal eines Magnetfeldsensors ändert.

9. Schalter (10) nach einem der vorhergehenden Ansprüche, **dadurch gekennzeichnet, dass** Rastmittel vorgesehen sind, die den Schieber (14) in der jeweiligen Schaltstellung halten.

10. Schalter (10) nach einem der vorhergehenden Ansprüche, **dadurch gekennzeichnet, dass** der Schalter (10) zwei Magnetfeldsensoren und maximal vier Schaltstellungen oder drei Magnetfeldsensoren (26.1, 26.2, 26.3) und maximal acht Schaltstellungen (ST1 bis ST8) umfasst.

11. Schalter (10) nach einem der vorhergehenden Ansprüche, **dadurch gekennzeichnet, dass** die Schaltstücke (20) aus Kunststoff sind und dass die Dauermagnete (24) in die Schaltstücke (20) eingeformt sind oder an diesen befestigt sind.

12. Schalter (10) nach einem der vorhergehenden Ansprüche, **dadurch gekennzeichnet, dass** die Magnetfeldsensoren (26) als auf einer Leiterplatte angeordnete Hall-ICs ausgebildet sind.

13. Auswerteeinheit (38) mit einem Schalter nach einem der vorhergehenden Ansprüche, die aus dem jeweiligen Schaltcode eine zugehörige Schaltstellung bestimmt und einen entsprechenden Schaltvorgang einleitet.

14. Auswerteeinheit (38) nach dem vorhergehenden Anspruch, **dadurch gekennzeichnet, dass** sie die Abfolge der Schaltcodes auf Plausibilität und/oder Redundanz überprüft.

15. Auswerteeinheit (38) nach Anspruch 13 oder 14, **dadurch gekennzeichnet, dass** die Auswerteeinheit den unmittelbar von den Magnetfeldsensoren (26) erzeugten Schaltcode auswertet.

16. Auswerteeinheit (38) nach Anspruch 13, 14 oder 15, **dadurch gekennzeichnet, dass** der von den Magnetfeldsensoren (26) erzeugte Schaltcode vor einer Auswertung durch die Auswerteeinheit in ein digitales Signal umgewandelt wird.

## Claims

1. Switch (10), in particular a vehicle switch, having a slide (14) which can be coupled to an operating element, is mounted such that it can be displaced along a displacement direction (12) and can be moved to defined switching positions (ST1 to ST8), with the slide (14) being at least conditionally coupled in terms of movement to at least two permanent magnets (24), which each have a south pole section and/or a north pole section, via switching pieces (20), and having at least two magnetic field sensors (26) which are arranged fixed in position in relation to the slide (14), are each associated with a permanent magnet (24) and of which the output signals, in each case as a function of the switching position (ST1 to ST8) of the slide (14), depend on whether a south pole section or a north pole section of the respective permanent magnet (24) is in the detection region of the respective magnetic field sensor (26), and of which the output signals form a binary switching code, which can be unambiguously determined, in the respective switching position (ST1 to ST8), **characterized in that** the switching pieces (20) in each case have a guide pin (30) for coupling in terms of movement to the slide (14), and **in that** the slide (14) for each guide pin (30) has a slotted guide (28) for guiding the respective guide pin (30).

2. Switch (10) according to Claim 1, **characterized in that** either a north pole section or a south pole section of the permanent magnet (24), which is associated with the respective magnetic field sensor (26), is present in the detection regions of the magnetic field sensors (26) in each switching position (ST1 to ST8) of the slide (14).

3. Switch (10) according to Claim 1 or 2, **characterized in that** the switch comprises a holder (18) which guides the slide (14) in a displaceable manner along a displacement direction (12) which runs in a straight line, and/or on which the switching pieces (20) are arranged in a moveable manner in such a way that they change their relative position with respect to the magnetic field sensors (26) as a function of the switching position of the slide (14).

4. Switch (10) according to Claim 1, 2 or 3, **characterized in that** the switching pieces (20) are arranged, such that they can be moved between two slide end positions, at least largely perpendicular to the displacement direction (12) of the slide (14).

5. Switch (10) according to Claim 1, 2 or 3, **characterized in that** the switching pieces (20) are arranged such that they can pivot between two pivot end positions.

6. Switch (10) according to one of the preceding claims, **characterized in that** the slotted guides (28) have subsections (32, 34) which run parallel to one another and parallel to the displacement direction.

7. Switch (10) according to one of the preceding claims, **characterized in that** the slotted guides (28) have, in the region of at least one open end, opening-widening means (37), which extend transverse to the displacement direction, for facilitating insertion of the guide pins (30).

8. Switch (10) according to one of the preceding claims, **characterized in that** the south pole sections and the north pole sections of the permanent magnets (24) and/or, if referring back to Claim 8, the slotted guides (28) are arranged in such a way that the switching code changes by only one output signal of a magnetic field sensor when the slide (14) is displaced from one switching position to an adjacent switching position.

9. Switch (10) according to one of the preceding claims, **characterized in that** latching means are provided which hold the slide (14) in the respective switching position.

10. Switch (10) according to one of the preceding claims, **characterized in that** the switch (10) comprises two magnetic field sensors and a maximum of four switching positions or three magnetic field sensors (26.1, 26.2, 26.3) and a maximum of eight switching positions (ST1 to ST8).

11. Switch (10) according to one of the preceding claims, **characterized in that** the switching pieces (20) are composed of plastic, and **in that** the permanent magnets (24) are integrally formed in the switching pieces (20) or are attached to said switching pieces.

12. Switch (10) according to one of the preceding claims, **characterized in that** the magnetic field sensors (26) are in the form of Hall ICs which are arranged on a printed circuit board.

13. Evaluation unit (38) having a switch according to one of the preceding claims, which evaluation unit determines an associated switching position from the respective switching code and initiates a corresponding switching process.

14. Evaluation unit (38) according to the preceding claim, **characterized in that** it checks the sequence of the switching code for plausibility and/or redundancy.

15. Evaluation unit (38) according to Claim 13 or 14, **characterized in that** the evaluation unit evaluates the switching code which is generated directly by the magnetic field sensors (26).

16. Evaluation unit (38) according to Claim 13, 14 or 15, **characterized in that** the switching code which is generated by the magnetic field sensors (26) is converted into a digital signal before evaluation by the evaluation unit.

## Revendications

1. Commutateur (10), notamment commutateur de véhicule, comprenant un curseur (14) pouvant être couplé avec un élément d'actionnement, logé de manière à pouvoir coulisser le long d'un sens de coulissement (12) et pouvant être amené dans des positions de commutation (ST1 à ST8) définies, le curseur (14) ayant un couplage à mobilité au moins conditionnel par le biais d'éléments de commutation (20) avec au moins deux aimants permanents (24) présentant chacun au moins une section de pôle sud et/ou de pôle nord, et comprenant au moins deux détecteurs de champ magnétique (26) disposés en un endroit fixe par rapport au curseur (14) et à chaque fois associés à un aimant permanent (24), dont les signaux de sortie, suivant la position de commutation (ST1 à ST8) du curseur (14), dépendent de la présence d'une section de pôle sud ou de pôle nord de l'aimant permanent (24) correspondant dans la zone de détection du détecteur de champ magnétique (26) correspondant et dont les signaux de sortie dans la position de commutation (ST1 à ST8) correspondante forment un code de commutation binaire pouvant être déterminé explicitement, **caractérisé en ce que** les éléments de commutation (20), pour le couplage à mobilité avec le curseur (14), présentent chacun un tenon de guidage (30) et **en ce que** le curseur (14) présente pour chaque tenon de guidage (30) un guide à coulisse (28) pour guider le tenon de guidage (30) correspondant.

2. Commutateur (10) selon la revendication 1, **caractérisé en ce que**, dans chaque position de commutation (ST1 à ST8) du curseur (14), il existe dans les zones de détection des détecteurs de champ magnétique (26) une section soit de pôle nord, soit de pôle sud de l'aimant permanent (24) associé au détecteur de champ magnétique (26) correspondant.

3. Commutateur (10) selon la revendication 1 ou 2, **caractérisé en ce que** le commutateur comprend un support (18) qui réalise un guidage coulissant du curseur (14) le long d'un sens de coulissement (12) rectiligne et/ou au niveau duquel les éléments de commutation (20) sont disposés avec mobilité de telle sorte qu'ils modifient leur position relative par rapport aux détecteurs de champ magnétique (26) en fonction de la position de commutation du curseur (14).

4. Commutateur (10) selon la revendication 1, 2 ou 3, **caractérisé en ce que** les éléments de commutation (20) sont disposés avec mobilité entre deux positions finales de coulissement au moins pour l'essentiel perpendiculairement au sens de coulissement (12) du curseur (14).

5. Commutateur (10) selon la revendication 1, 2 ou 3, **caractérisé en ce que** les éléments de commutation (20) sont disposés de manière à pouvoir pivoter entre deux positions finales de pivotement.

6. Commutateur (10) selon l'une des revendications précédentes, **caractérisé en ce que** les guides à coulisse (28) présentent des sections partielles (32, 34) parallèles l'une à l'autre et parallèles au sens de coulissement.

7. Commutateur (10) selon l'une des revendications précédentes, **caractérisé en ce que** les guides à coulisse (28) présentent, dans la zone d'au moins une extrémité ouverte, des élargissements d'ouverture (37) qui s'étendent transversalement par rapport au sens de coulissement en vue de faciliter l'introduction des tenons de guidage (30).

8. Commutateur (10) selon l'une des revendications précédentes, **caractérisé en ce que** les sections de pôle sud et de pôle nord des aimants permanents (24) et/ou, en se référant à la revendication 8, les guides à coulisse (28) sont disposés de telle sorte que, lorsque le curseur (14) coulisse d'une position de commutation à une position de commutation voisine, le code de commutation ne change que d'un seul signal de sortie d'un détecteur de champ magnétique.

9. Commutateur (10) selon l'une des revendications précédentes, **caractérisé en ce que** des moyens d'enclenchement sont prévus, lesquels maintiennent le curseur (14) dans la position de commutation correspondante.

10. Commutateur (10) selon l'une des revendications précédentes, **caractérisé en ce que** le commutateur (10) comprend deux détecteurs de champ magnétique et un maximum de quatre positions de commutation ou trois détecteurs de champ magnétique (26.1, 26.2, 26.3) et un maximum de huit positions de commutation (ST1 à ST8).

11. Commutateur (10) selon l'une des revendications précédentes, **caractérisé en ce que** les éléments de commutation (20) sont en matière plastique et **en ce que** les aimants permanents (24) sont moulés dans les éléments de commutation (20) ou fixés sur ceux-ci.

12. Commutateur (10) selon l'une des revendications précédentes, **caractérisé en ce que** les détecteurs de champ magnétique (26) sont réalisés sous la forme de circuits intégrés à effet Hall disposés sur un circuit imprimé.

13. Unité d'interprétation (38) comprenant un commutateur selon l'une des revendications précédentes, lequel détermine une position de commutation associée à partir du code de commutation correspondant et initie une opération de commutation correspondante.

14. Unité d'interprétation (38) selon la revendication précédente, **caractérisée en ce qu'**elle vérifie la plausibilité et/ou la redondance de la séquence du code de commutation.

15. Unité d'interprétation (38) selon la revendication 13 ou 14, **caractérisée en ce que** l'unité d'interprétation interprète le code de commutation généré directement par les détecteurs de champ magnétique (26).

16. Unité d'interprétation (38) selon la revendication 13, 14 ou 15, **caractérisée en ce que** le code de commutation généré par les détecteurs de champ magnétique (26) est converti en un signal numérique avant une interprétation par l'unité d'interprétation.
